# EUROPÄISCHE PATENTANMELDUNG

(11) **EP 1 577 545 A1**
(43) Veröffentlichungstag der Anmeldung: **21.09.2005**
(21) Anmeldenummer: 05005300.8
(22) Anmeldetag: 10.03.2005
(51) Int. Cl.: F02P 3/05, H03K 17/16

(54) **Verfahren und Schaltvorrichtung zum Betreiben einer Zündspule eines Kraftfahrzeugs**

(30) Priorität: 19.03.2004 DE 102004013561
(71) Anmelder: AUDI AG, 85045 Ingolstadt (DE)
(72) Erfinder: Sterler, Georg, 85098 Großmehring (DE); Bast, Josef, 85053 Ingolstadt (DE); Rapp, Franz-Josef, 91091 Großenseebach (DE)
(74) Vertreter: Thielmann, Frank

(57) **Zusammenfassung**

Verfahren zum Betreiben einer Zündspule eines Kraftfahrzeugs umfassend ein Steuergerät für die Zündelektronik und eine Zündelektronik mit einer linear ansteuerbaren und eine Steuerspannung liefernden Endstufe zum Ansteuern der Zündspule, wobei während des Ein- und/oder Ausschaltvorgangs der Zündspule unter Verwendung eines vom Steuergerät gelieferten Zündsignals auf den zeitlichen Verlauf bezogene Soll- und Istwerte für die Steuerspannung der Zündspule ermittelt und verglichen werden und in Abhängigkeit des Vergleichsergebnisses eine Regelung der Endstufe und damit eines Ein- und/oder Ausschaltsignals für die Zündspule derart erfolgt, dass die Änderung der Steuerspannung im kontinuierlichen Zeitverlauf eine stetige Kurve mit endlicher Steigung beschreibt und somit die Flankensteilheit des Ein- und/oder Ausschaltsignals der Spule begrenzt wird.

## Beschreibung

Die Erfindung betrifft ein Verfahren zum Betreiben einer Zündspule eines Kraftfahrzeugs umfassend ein Steuergerät für die Zündelektronik und eine Zündelektronik mit einer linear ansteuerbaren und eine Steuerspannung liefernden Endstufe zum Ansteuern der Zündspule.

Die Zündspule eines Kraftfahrzeugs wird üblicherweise über einen Schalter digital ein- und ausgeschaltet. Die dabei auftretenden Sprungfunktionen führen aufgrund ihrer in einer entsprechenden Fourierzerlegung sichtbaren hochfrequenten Anteile zu EMV-Störungen. Beim Einschalten der Spule entsteht ein Einschaltstromstoß, dessen Ursache in den in jeder realen Schaltanordnung vorhandenen "parasitären" Kondensatoren in der Spule und ihrem Umfeld liegt. Dieser Stromstoß im Primärkreis der Zündvorrichtung erzeugt im Sekundärkreis des Zündtransformators einen unerwünschten Spannungsstoß, der zu einer Frühzündung führen kann.

Der Erfindung liegt daher die Aufgabe zugrunde, ein Verfahren zum Betreiben einer Zündspule eines Kraftfahrzeugs anzugeben, das eine verbesserte Ansteuerung der Zündspule erlaubt.

Zur Lösung dieser Aufgabe ist bei einem Verfahren der eingangs genannten Art erfindungsgemäß vorgesehen, dass während des Ein- und/oder Ausschaltvorgangs der Zündspule unter Verwendung eines vom Steuergerät gelieferten Zündsignals auf den zeitlichen Verlauf bezogene Soll- und Istwerte für die Steuerspannung der Zündspule ermittelt und verglichen werden und in Abhängigkeit des Vergleichsergebnisses eine Regelung der Endstufe und damit eines Ein- und/oder Ausschaltsignals für die Zündspule derart erfolgt, dass die Änderung der Steuerspannung im kontinuierlichen Zeitverlauf eine stetige Kurve mit endlicher Steigung beschreibt und somit die Flankensteilheit des Ein- und/oder Ausschaltsignals der Spule begrenzt wird.

Bei einer begrenzten Flankensteilheit des Ein- und/oder Ausschaltsignals der Spule fallen besonders hochfrequente Anteile weg, so dass bezüglich der EMV-Störungen eine Verbesserung erhalten wird. Das erfindungsgemäße Verfahren passt die Ansteuerung der Spule den Gegebenheiten des Magnetkreises an, denn sowohl die Zündspule des Primärkreises als auch die Zündspule des Sekundärkreises umfassen einen Eisenkern, wobei sich die Magnetisierung im Eisenkern langsamer ändert, als das Ein- oder Ausschalten der Zündspule möglich ist. Das erfindungsgemäße langsamere Einschalten der Spule begrenzt den Einschaltstrom, so dass Frühzündungen verhindert werden. Außerdem bleibt der Magnetkreis von Schockbelastungen verschont.

In einer ersten Ausgestaltung der Erfindung ist vorgesehen, dass als Vergleichsergebnis in einer Vergleicherschaltung eine Regelabweichung bestimmt und verarbeitet wird. Die Regelabweichung ist eine aussagekräftige und leicht zu verarbeitende Größe, die anhand der Soll- und Istwerte für die Steuerspannung mit Hilfe einer einfach aufgebauten Vergleicherschaltung bestimmt werden kann.

Vorteilhaft erfolgt die Bestimmung und Verarbeitung in der Vergleicherschaltung mittels eines Operationsverstärkers oder einer vergleichbaren Differenzverstärkerschaltung. Die Verwendung eines standardmäßigen Operationsverstärkers stellt dabei eine besonders einfache und kostengünstige Lösung dar. Je nach den Erfordernissen der speziellen Zündelektronik können aber auch andere, entsprechend angepasste Differenzverstärkerschaltungen verwendet werden.

In einer Ausgestaltung der Erfindung ist vorgesehen, dass die Sollwerte über den Auf- und/oder Entladevorgang eines Kondensators in einer das Zündsignal des Steuergeräts als Eingabe erhaltenden Eingangsschaltung ermittelt werden. Wenn das Steuergerät beispielsweise als Zündsignal einen Rechteckimpuls liefert, so ist hieraus ein Sollwertsignal ableitbar, wobei verwendet wird, dass die Spannung an einem Kondensator nur langsam ansteigt (Soft on) und auch entsprechend vergleichsweise langsam wieder abfällt (Soft off), wenn der Kondensator wieder entladen wird. Dabei können die Auflade- bzw. Entladefunktionen auch vertauscht werden. Der Kondensator bietet sich als Standardbauteil mit allen nötigen Eigenschaften für die Sollwertermittlung an.

Eine weitere alternative Ausgestaltung der Erfindung sieht vor, dass der Soll-/Istwertvergleich mittels eines in einer Speichervorrichtung ablegten Programmmittels durchgeführt wird. Damit ist eine alternative Realisierung zu einer Vergleicherschaltung möglich. Die Verwendung einer Speichervorrichtung mit einem Programmmittel hat den Vorteil, dass die Programmmittel auf unterschiedliche Situationen, die im Kraftfahrzeugbetrieb auftreten können, abgestimmt werden können. Das jeweils bestimmte Vergleichsergebnis kann eine andere Größe sein oder aber es können äußere Parameter, beispielsweise ein lange oder nur kurze Zeit zurückliegender letzter Zündvorgang, berücksichtigt werden.

Weiterhin kann es vorteilhaft sein, wenn die Sollwertermittlung mit Hilfe eines in einer Speichervorrichtung abgelegten Programmmittels durchgeführt wird. Zweckmäßigerweise wird dieses Programmmittel ebenfalls zur Durchführung des Soll-/Istwertvergleichs ausgebildet sein. Bei dieser Art der Sollwertermittlung wird der Kondensator in der Eingangsschaltung überflüssig, zudem erlaubt eine Sollwertermittlung über ein Programmmittel eine variablere Bestimmung, in die wiederum äußere Parameter einfließen können.

Gemäß einer Weiterentwicklung der Erfindung wird das Programmmittel in Abhängigkeit des Zündsignals des Steuergeräts bei Bedarf definiert gesetzt. Hierzu wird das Zündsignal des Steuergeräts an den Resetport eines Mikrocomputers angelegt, der unter anderem die Speichervorrichtung umfasst, in der das Programmmittel abgelegt ist. So wird zunächst aus dem Ansteuersignal ein Reset erzeugt, erst im Anschluss laufen die Routinen beispielsweise für den Sollwert ab. Damit wird eine höhere Sicherheit gegenüber Störspannungen erreicht.

Eine Ausgestaltung des erfindungsgemäßen Verfahrens ist dadurch gekennzeichnet, dass die Regelung derart erfolgt, dass die Steuerspannung für den Ein- und/oder Ausschaltvorgang im kontinuierlichen Zeitverlauf eine Rampe beschreibt. Dabei ist ein rampenartiger linearer Verlauf zweckmäßig, um auf einfache Weise ein langsames Ansteigen bzw. Abfallen unter Verwendung linear arbeitender Standardbauteile zu erreichen. Ein rampenartiger Verlauf bezeichnet hier neben rein linearen Verläufen auch "rundere", verschliffene Verläufe. Entscheidend ist, dass Sprünge zugunsten "weicher", kontinuierlicher Übergänge zwischen einzelnen Bereichen vermieden werden. Außerdem ist es vorteilhaft, wenn die Spannungsrampe für einen möglichen Einschaltvorgang flacher verläuft als die Rampe für einen möglichen Ausschaltvorgang. Die Rampe für den Ausschaltvorgang darf nicht zu flach sein, da sonst die an der Sekundärspule induzierte Spannung nicht groß genug ist, um den Zündfunken auszulösen. Ein in gewissen Grenzen verlangsamtes Ausschalten ist jedoch möglich, da die Sekundärspule eine gewisse Zeit benötigt, um die Energie der Primärspule aufzunehmen. Wenn das Steuergerät ein Zündsignal in Form eines Rechtecks mit beispielsweise 2 msec Impuls und 20 msec Pause liefert, aus dem ein Sollwertsignal abgeleitet wird, wobei ein Kondensator auf- und entladen wird, so ist in diesem Falle für das Aufladen des Kondensators typischerweise eine Zeit von 50 bis 100 µsec anzusetzen, das Entladen wird dann im µs-Bereich erfolgen.

Zweckmäßigerweise erfolgt das Ansteuern der Zündspule in der Endstufe über einen Leistungshalbleiter, insbesondere einen bipolaren Transistor oder einen IGB-Transistor. Diese linear arbeitenden Bauteile sind elektronische Standardbauteile. Zweckmäßigerweise wird der jeweilige Istwert am Knotenpunkt zwischen Zündspule und Leistungshalbleiter ermittelt.

Daneben betrifft die Erfindung eine Schaltvorrichtung zum Betreiben einer Zündspule eines ein Steuergerät für die Zündelektronik umfassenden Kraftfahrzeugs mit einer linear ansteuerbaren und eine Steuerspannung liefernden Endstufe zum Ansteuern der Zündspule, die dadurch gekennzeichnet ist, dass die Schaltvorrichtung Mittel zur Ermittlung und zum Vergleich auf den zeitlichen Verlauf bezogener Soll- und Istwerte für die Steuerspannung der Zündspule in der Endstufe unter Verwendung eines vom Steuergerät gelieferten Zündsignals sowie zur Regelung der Endstufe und damit eines Ein-und/oder Ausschaltsignals für die Zündspule derart, dass die Änderung der Steuerspannung im kontinuierlichen Zeitverlauf eine stetige Kurve mit endlicher Steigung beschreibt und somit die Flankensteilheit des Ein- und/oder Ausschaltsignals der Spule begrenzt wird, umfasst.

Analog zum erfindungsgemäßen Verfahren können somit die EMV-Störungen verringert und Schockbelastungen des Magnetkreises verhindert werden.

Eine Ausgestaltung sieht vor, dass die Mittel zum Vergleich der Soll- und Istwerte eine Vergleicherschaltung zur Bestimmung und Verarbeitung einer Regelabweichung umfassen. Diese Vergleicherschaltung umfasst ihrerseits zweckmäßigerweise einen Operationsverstärker oder einen vergleichbaren Differenzverstärker, wodurch eine einfache Realisierung gewährleistet ist.

Eine Weiterbildung sieht vor, dass die Schaltvorrichtung eine das Zündsignal des Steuergeräts als Eingabe erhaltende Eingangsschaltung mit einem Kondensator sowie Mittel zur Bestimmung der Sollwerte über den Auf- und/oder Entladevorgang des Kondensators umfasst.

Daneben kann es vorteilhaft sein, wenn die Mittel ein in einer Speichervorrichtung abgelegtes Programmmittel zum Soll-/Istwertvergleich umfassen. Ein in einer anderen oder der gleichen Speichervorrichtung abgelegtes Programmmittel, das mit dem Programmmittel zum Soll-/Istwertvergleich identisch sein kann, ist vorteilhafterweise zur Sollwertermittlung ausgebildet. In diesem Fall werden die Sollwertermittlung sowie der Vergleich der Soll- und Istwerte kompakt mit einer Softwarelösung realisiert. Dadurch kann eine nachträgliche Umrüstung auf die erfindungsgemäße Schaltvorrichtung erleichtert werden.

Eine Ausgestaltung der Erfindung sieht vor, dass die Mittel zum definierten Setzen des Programmmittels über den Resetport eines die Speichervorrichtung umfassenden Mikrocomputers in Abhängigkeit des Zündsignals des Steuergeräts ausgebildet sind. Diese Betriebsart erlaubt eine erhöhte Sicherheit gegenüber Störspannungen. Selbstverständlich muss der Reset jedoch nicht als Eingang benutzt werden. Alternativ kann ein Resetsignal mit der Standardbeschaltung des Prozessors erzeugt werden, z. B. durch einen Widerstand oder eine RC-Kombination.

Gemäß einer Weiterbildung der Erfindung ist vorgesehen, dass die Mittel zur Regelung derart ausgebildet sind, dass die Steuerspannung im kontinuierlichen Zeitverlauf eine Rampe beschreibt. Dabei ist es zweckmäßig, wenn die Spannungsrampe für einen möglichen Einschaltvorgang flacher verläuft als die Rampe für einen möglichen Ausschaltvorgang.

Da eine lineare Ansteuerung der Endstufe erwünscht ist, ist es vorteilhaft, wenn die Endstufe einen Leistungshalbleiter, insbesondere einen bipolaren Transistor oder einen IGB-Transistor, zum Ansteuern der Zündspule umfasst. In diesem Fall umfasst die Endstufe zweckmäßigerweise Mittel zur Ermittlung der Istwerte der Steuerspannung am Knotenpunkt zwischen Zündspule und Leistungshalbleiter.

Weitere Vorteile, Merkmale und Einzelheiten der Erfindung werden nachfolgend anhand besonders geeigneter Ausführungsbeispiele beschrieben. Dabei zeigen:
- Fig. 1: ein Flussdiagramm des erfindungsgemäßen Verfahrens zum Betreiben einer Zündspule;
- Fig. 2: eine erfindungsgemäße Schaltvorrichtung mit einem Operationsverstärker;
- Fig. 3: eine Darstellung des erfindungsgemäßen Verfahrens im zeitlichen Ablauf;
- Fig. 4: eine erfindungsgemäße Schaltvorrichtung mit einer Speichereinrichtung;
- Fig. 5: Emissionsspektren eines Zündtransformators bei Durchführung des erfindungsgemäßen Verfahrens mit anliegendem Ohmschen Lastwiderstand.
- Fig. 6: eine Schaltvorrichtung gemäß Fig. 4 mit veränderter Reseterzeugung; und
- Fig. 7: eine Ablaufdarstellung des erfindungsgemäßen Verfahrens bei Verwendung der zu Fig. 6 beschriebenen Reseterzeugung.

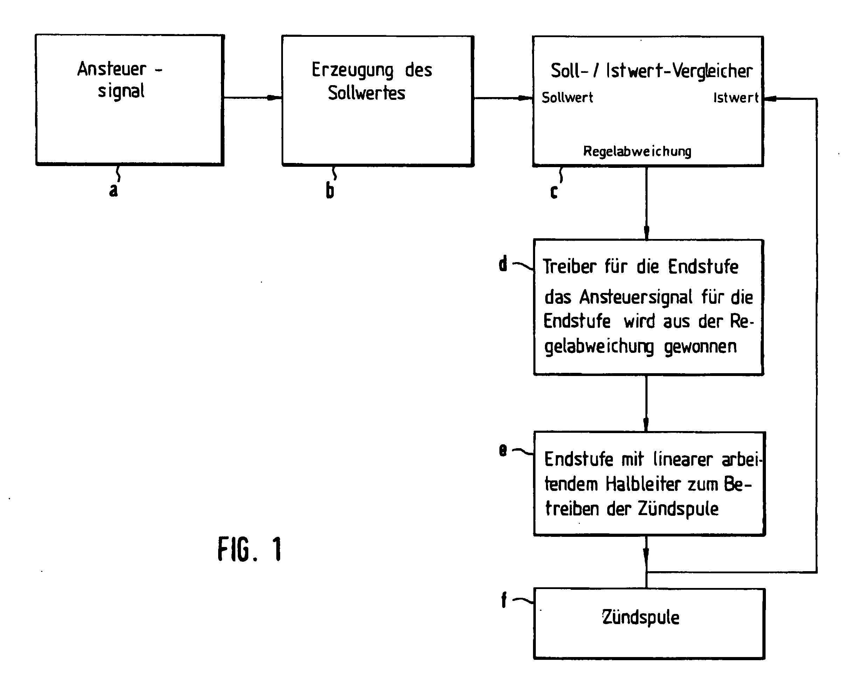

Fig. 1 zeigt ein Flussdiagramm des erfindungsgemäßen Verfahrens zum Betreiben einer Zündspule. Im Schritt a erzeugt dabei zunächst ein Steuergerät für die Zündelektronik ein Ansteuersignal, das der Eingangsschaltung der Zündelektronik als Eingabe dient. Im folgenden Schritt b wird ein Sollwert erzeugt, wobei dies mit Hilfe eines Kondensators in der Eingangsschaltung geschehen kann, aber auch über ein in einer Speichervorrichtung abgelegtes Programmmittel. Der Sollwert aus Schritt b dient zusammen mit einem Istwert, der zwischen der Zündspule und einem als Schalter dienenden Halbleiter abgegriffen wird und aus der Halbleiterspannung oder der an der Zündspule anliegenden Spannung ermittelt wird, einem Soll-/Istwert-Vergleicher als Eingangssignal. Aus dem Vergleich der Soll- und Istwerte wird im Schritt c durch den Soll-/Istwert-Vergleicher eine Regelabweichung bestimmt, die ein Treiber für die Endstufe als Eingabe erhält, um aus der Regelabweichung im Schritt d das Ansteuersignal für die Endstufe zu gewinnen. Je nachdem wie häufig ein Vergleich der Soll- und Istwerte erfolgt und wie die Toleranzabweichungen vorgegeben werden, kann ein entsprechend präzises Ansteuersignal ermittelt werden. Das Ansteuersignal wird im Schritt e von der Endstufe verarbeitet, die in diesem Fall einen linear arbeitenden Halbleiter, beispielsweise einen bipolaren Transistor oder einen IGB-Transistor, zum Betreiben der Zündspule umfasst. Das von der Endstufe erzeugte Steuersignal steuert im Schritt f die Zündspule. Der Istwert, der am Knotenpunkt zwischen Spule und Halbleiter ermittelt wird, wird zur Bestimmung der Regelabweichung an den Soll-/Istwert-Vergleicher zur Berechnung der Regelabweichung im Schritt c geliefert.

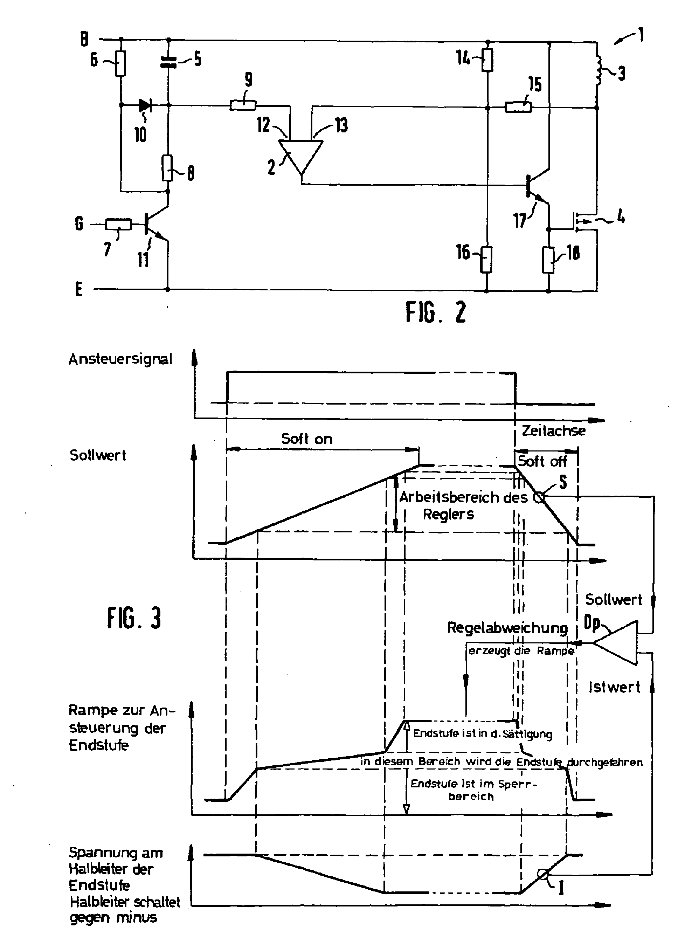

Fig. 2 ist eine Darstellung einer erfindungsgemäßen Schaltvorrichtung 1 mit einem Operationsverstärker 2. Die Schaltvorrichtung 1 umfasst dabei eine Zündspule 3, deren einer Anschluss an einem Leistungshalbleiter 4 anliegt. Zur Sollwertmittlung dient der Auf- bzw. Entladevorgang eines Kondensators 5 in der Eingangsschaltung, die neben den Widerständen 6, 7 und 8 und der Diode 10 einen Transistor 11 umfasst. Der Widerstand 9 ist ein Begrenzungswiderstand für den Operationsverstärker 2. Die Eingangsschaltung bildet gleichzeitig den Abschluss des vorgeschalteten Steuergeräts für die Zündelektronik. Am Eingang B liegt die von der Batterie gelieferte Versorgungsspannung an, G ist der vom Steuergerät der Zündelektronik angesteuerte Eingang der Elektronik, und der Eingang E liegt auf Masse. Den Vergleich des am Kondensator 5 bestimmten Sollwerts mit den an der Spule 3 bestimmten Istwerten leistet im dargestellten Fall ein Operationsverstärker 2 mit den beiden Eingängen 12 und 13 für die Soll- bzw. Istwerte, der die Vergleicherschaltung bildet. Alternativ sind andere Differenzverstärkerschaltungen möglich. Die Kapazität des Kondensators 5 ist derart zu wählen, dass die gewünschten Rampenverläufe mit einem langsamen Anstieg bzw. Abfall der Spannung an der Spule 3 erreicht werden können. Die Widerstände 14, 15 und 16 bilden den Istwertbereich, der das Eingangssignal für den zweiten Eingang 13 des Operationsverstärkers 2 liefert. Die vom Operationsverstärker 2 ermittelte Regelabweichung erhält der Treiberbereich zur Erzeugung des Ansteuersignals für die Endstufe, der den Transistor 17 und den Widerstand 18 umfasst. Die Endstufe mit dem Leistungshalbleiter 4 steuert entsprechend dem Ansteuersignal die Zündspule 3.

Fig. 3 ist eine Darstellung des erfindungsgemäßen Verfahrens im zeitlichen Ablauf, wobei jeweils das Ansteuersignal für die Zündelektronik, der Sollwert, die Rampe zur Ansteuerung der Endstufe sowie die Spannung am Halbleiter der Endstufe gegen die Zeit aufgetragen sind. Das Ansteuersignal, das das Steuergerät für die Zündelektronik liefert, hat im dargestellten Fall die Form eines Rechteckimpulses. Daraus abgeleitet wird ein Sollwertsignal mit einem rampenartigen langsamen Anstiegsbereich, in dem der Arbeitsbereich des Reglers zum Betreiben der Zündspule liegt, sowie einem etwas schnelleren ebenfalls rampenartigen Abfall. Der Anstiegsbereich beschreibt den sogenannten "Soft on"-Bereich des langsamen Spannungsanstiegs, der Bereich des Spannungsabfalls steht für "Soft off", das langsame Abschalten der Spule. Zu einem bestimmten Zeitpunkt wird der entsprechende aktuelle Sollwert S an einen Vergleicher geliefert, der außerdem aus der Spannung am Istwertknoten zwischen dem Halbleiter der Endstufe und der Zündspule einen Istwert I erhält. Der Vergleicher ist im dargestellten Fall ein Operationsverstärker Op mit den beiden Eingängen E1 und E2. Der Vergleich von Soll- und Istwert zu einer bestimmten Zeit ermöglicht die Bestimmung einer Regelabweichung. Aus dieser Regelabweichung wiederum ergibt sich die Rampe zur Ansteuerung der Endstufe. Der Bereich, in dem die Endstufe durchfahren wird, ist dabei durch den Sperrbereich gegen niedrigere Spannungen, durch den Sättigungsbereich gegenüber höheren Spannungen abgegrenzt. Die Spannung am Halbleiter der Endstufe hat ein demgegenüber umgekehrtes "Anstiegs-" bzw. "Abfallverhalten", da der Halbleiter an sich ein Inverter ist, der gegen Minus schaltet. Ein umgekehrtes Verhalten ist denkbar. Die vertikalen Verbindungslinien zeigen die verschiedenen Werte von Ansteuersignal, Sollwert, Rampe zur Ansteuerung der Endstufe und Spannung am Halbleiter der Endstufe zu gleichen für das Verfahren charakteristischen Zeitpunkten.

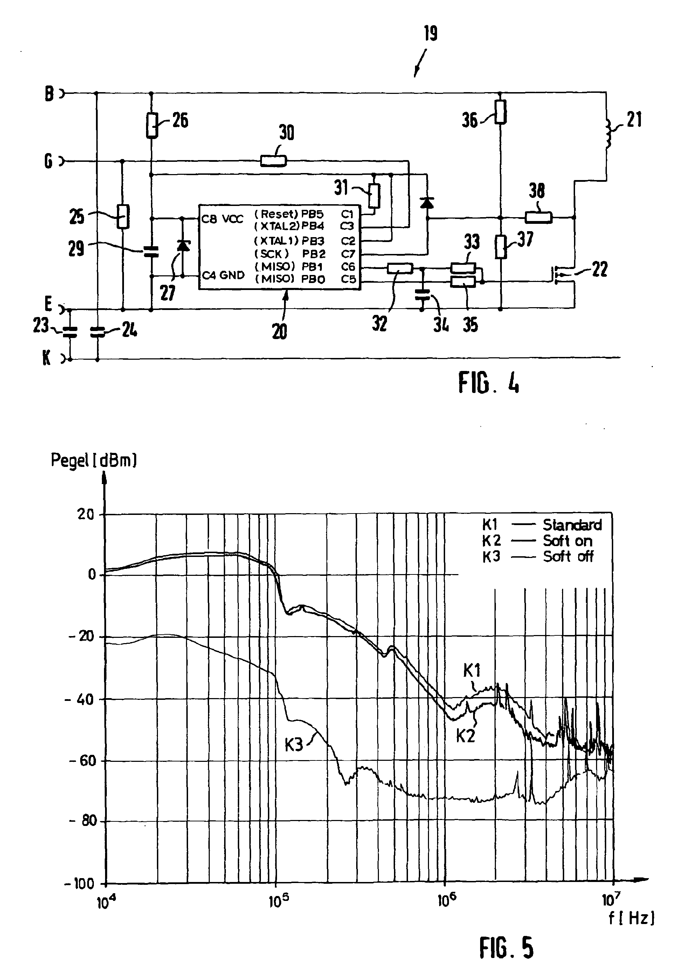

Fig. 4 ist eine Darstellung einer erfindungsgemäßen Schaltvorrichtung 19 mit einer Speichereinrichtung, die Teil eines Mikrocomputers 20 ist. Die Zündspule 21 liegt mit einem Anschluss am Leistungshalbleiter 22 an, mit dem anderen Anschluss an der Batterie, die am Eingang B die Versorgungsspannung für die Zündelektronik liefert. G ist der vom Steuergerät der Zündelektronik angesteuerte Eingang, der mit dem Port C3 des Mikrocomputers verbunden ist, am Eingang E liegt eine erste Masse, an K eine zweite Masse. Die Kondensatoren 23, 24 dienen der Entstörung. Der Eingangswiderstand 25 der Eingangsschaltung ist gleichzeitig Abschlusswiderstand für ein vorgeschaltetes Steuergerät. Der Vorwiderstand 26 begrenzt den Strom der Zenerdiode 27, deren Aufgabe darin besteht, die am Mikrocomputer 20 an den Pins C8 und C4 anliegende Spannung zu begrenzen. Zur Absicherung der Spannung der Zenerdiode ist ein Stützkondensator 29 vorgesehen. Der Widerstand 30 begrenzt den Strom am Eingang PB4 des Mikrocomputers 20. Mit Hilfe des Widerstands 31 und des Ports C1 des Mikrocomputers 20 ist es möglich, ein Resetsignal zum Zurücksetzen eines in der Speichereinrichtung abgelegten Programmmittels zu erhalten. Über den Port C2 erfolgt die notwendige Beschaltung des Mikrocomputers 20, und über den Anschluss C3 wird ein Istwertsignal analog erkannt. Das in der Speichereinrichtung des Mikrocomputers 20 gespeicherte Programmmittel gibt die Sollwerte für den Soll-/Istwertvergleich vor. Außerdem führt das Programmmittel den Soll-/Istwertvergleich durch und berechnet das Vergleichsergebnis. Je nach Ergebnis erfolgt die Ansteuerung der Endstufe mit dem linear arbeitenden Halbleiter 22 über die Ports C5 und C6. Die Widerstände 32 und 33 und der Kondensator 34 ermöglichen ein weiches Schalten des Leistungshalbleiters 22, über den Widerstand 35 wird der Leistungshalbleiter hingegen "satt" geschaltet. Der Leistungshalbleiter 22 steuert seinerseits die Zündspule 21 linear durch. Die Widerstände 36, 37, 38 bilden den Istwertbereich, in dem der Istwert bestimmt und über den Anschluss C7 an den Mikrocomputer 20 geliefert wird.

In Fig. 5 ist das Emissionsspektrum eines Zündtransformators bei Durchführung des erfindungsgemäßen Verfahrens mit anliegendem Lastwiderstand zu sehen. Dargestellt ist jeweils der Pegel in dBm in Abhängigkeit von der in Hz angegebenen Frequenz. Da bei der Ermittlung des dargestellten Emissionsspektrums eine Ohmsche Last anlag, sind die Emissionsspektren nur qualitativ zu bewerten. Gezeigt werden neben einer Standardkurve K1 für den Normalbetrieb ohne langsames Ein- bzw. Ausschalten (soft on/off) die Kurven K2 für einen "Soft on"-Betrieb sowie K3 für den "Soft off"-Betrieb. Die Kurven K1 und K2 beginnen für Frequenzen von 10⁴ Hz mit Pegeln etwas über 0 dBm, steigen mit wachsenden Frequenzen zunächst an, um dann mit einem ähnlichen Verlauf mit Schwankungen im Wesentlichen auf einen Wert von etwa -50 bis -60 dBm für hohe Frequenzen abzufallen. Dabei weist K2 insbesondere im Bereich von etwa 10⁶ Hz niedrigere Pegel als K1 auf. Die Kurve K3 für den langsamen Abschaltvorgang K3 beginnt bei 10⁴ Hz mit einem Pegel von -20 dBm. Bei ansteigenden Frequenzen sinkt der Pegel zunächst mit kleinen Schwankungen relativ gleichmäßig auf -80 dbm ab, dann bleibt er bis etwa 10⁶ Hz konstant in diesem Bereich. Für höhere Frequenzen steigt der Pegel mit Schwankungen wieder an. Insgesamt sind die Emissionen gegenüber der Standardkurve K1 deutlich reduziert. Obwohl im dargestellten Fall ein Ohmscher Lastwiderstand anliegt, kann dennoch qualitativ geschlussfolgert werden, dass mit dem erfindungsgemäßen Verfahren eine Verringerung der EMV-Störungen erreicht wird.

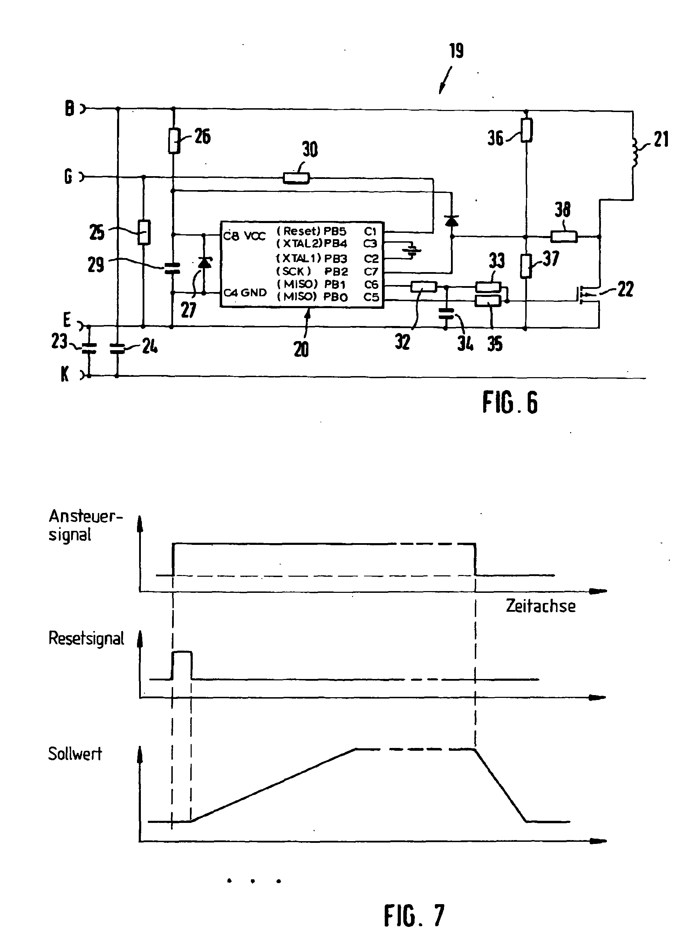

In Fig. 6 ist eine Schaltvorrichtung gemäß Fig. 4 mit veränderter Reseterzeugung dargestellt. Im Unterschied zur Darstellung der Fig. 4 fehlt hier der Widerstand 31. Stattdessen wird das Zündsignal des Steuergeräts direkt auf den Resetport C1 geleitet. Der Port C3, der nach Fig. 4 das Signal des vorgeschalteten Steuergeräts erhalten hat, ist hier über die Verbindung zum Port C2 beschaltet. Mit dieser Schaltung wird eine erhöhte Sicherheit gegenüber Störspannungen erreicht, da mit jedem Ansteuersignal zunächst ein Reset erzeugt wird, bevor die eigentliche Routinen wie in Fig. 3 beziehungsweise beispielhaft für den Sollwert mit Resetsignal in Fig. 7 gezeigt ablaufen.

Fig. 7 zeigt eine Ablaufdarstellung des erfindungsgemäßen Verfahrens bei Verwendung der zu Fig. 6 beschriebenen Reseterzeugung. Das Ansteuersignal hat wie in Fig. 3 gezeigt die Form eines Rechteckimpulses. Durch die anwendungsspezifische Beschaltung der Restports wird - in Verbindung mit dem Programmmittel ― ein kurzes Resetsignal erzeugt. Zur Verdeutlichung ist das Resetsignal in der Abbildung übertrieben lang dargestellt. Erst dieses Resetsignal veranlasst den Ablauf der Routinen, nach denen der Sollwert, die Rampe zur Ansteuerung der Endstufe oder die Spannung am Halbleiter der Endstufe abgeleitet werden. In der Abbildung ist lediglich beispielhaft der Sollwertverlauf gezeigt. Die Rampe zur Ansteuerung der Endstufe und die Spannung am Halbleiter der Endstufe haben einen Verlauf, wie er in Fig. 3 gezeigt ist. Der einzige Unterschied ist das in jeder Periode vorgeschaltete Resetsignal, wodurch der Betrieb gegenüber Störspannungen abgesichert wird.

## Patentansprüche

1. Verfahren zum Betreiben einer Zündspule eines Kraftfahrzeugs umfassend ein Steuergerät für die Zündelektronik und eine Zündelektronik mit einer linear ansteuerbaren und eine Steuerspannung liefernden Endstufe zum Ansteuern der Zündspule,
**dadurch gekennzeichnet,**
**dass** während des Ein- und/oder Ausschaltvorgangs der Zündspule unter Verwendung eines vom Steuergerät gelieferten Zündsignals auf den zeitlichen Verlauf bezogene Soll- und Istwerte für die Steuerspannung der Zündspule ermittelt und verglichen werden und in Abhängigkeit des Vergleichsergebnisses eine Regelung der Endstufe und damit eines Ein- und/oder Ausschaltsignals für die Zündspule derart erfolgt, dass die Änderung der Steuerspannung im kontinuierlichen Zeitverlauf eine stetige Kurve mit endlicher Steigung beschreibt und somit die Flankensteilheit des Ein- und/oder Ausschaltsignals der Spule begrenzt wird.

2. Verfahren nach Anspruch 1,
**dadurch gekennzeichnet,**
**dass** als Vergleichsergebnis in einer Vergleicherschaltung eine Regelabweichung bestimmt und verarbeitet wird.

3. Verfahren nach Anspruch 2,
**dadurch gekennzeichnet,**
**dass** die Bestimmung und Verarbeitung in der Vergleicherschaltung mittels eines Operationsverstärkers oder einer vergleichbaren Differenzverstärkerschaltung erfolgen.

4. Verfahren nach einem der vorangehenden Ansprüche,
**dadurch gekennzeichnet,**
**dass** die Sollwerte über den Auf- und/oder Entladevorgang eines Kondensators in einer das Zündsignal des Steuergeräts als Eingabe erhaltenden Eingangsschaltung ermittelt werden.

5. Verfahren nach einem der Ansprüche 1 oder 4,
**dadurch gekennzeichnet,**
**dass** der Soll-/Istwertvergleich mittels eines in einer Speichervorrichtung abgelegten Programmmittels durchgeführt wird.

6. Verfahren nach einem der Ansprüche 1 bis 3 oder 5,
**dadurch gekennzeichnet,**
**dass** die Sollwertermittlung mit Hilfe eines in einer Speichervorrichtung abgelegten Programmmittels durchgeführt wird.

7. Verfahren nach einem der Ansprüche 5 oder 6,
**dadurch gekennzeichnet,**
**dass** das Programmmittel in Abhängigkeit des Zündsignals des Steuergeräts bei Bedarf definiert gesetzt wird.

8. Verfahren nach einem der vorangehenden Ansprüche,
**dadurch gekennzeichnet,**
**dass** die Regelung derart erfolgt, dass die Steuerspannung für den Ein- und/oder Ausschaltvorgang im kontinuierlichen Zeitverlauf eine Rampe beschreibt.

9. Verfahren nach Anspruch 8,
**dadurch gekennzeichnet,**
**dass** die Spannungsrampe für einen möglichen Einschaltvorgang flacher verläuft als die Rampe für einen möglichen Ausschaltvorgang.

10. Verfahren nach einem der vorangehenden Ansprüche
**dadurch gekennzeichnet,**
**dass** das Ansteuern der Zündspule in der Endstufe über einen Leistungshalbleiter, insbesondere einen bipolaren Transistor oder einen IGB-Transistor, erfolgt.

11. Verfahren nach Anspruch 10,
**dadurch gekennzeichnet,**
**dass** die Istwerte der Steuerspannung am Knotenpunkt zwischen Zündspule und Leistungshalbleiter ermittelt werden.

12. Schaltvorrichtung zum Betreiben einer Zündspule eines ein Steuergerät für die Zündelektronik umfassenden Kraftfahrzeugs mit einer linear ansteuerbaren und eine Steuerspannung liefernden Endstufe zum Ansteuern der Zündspule, **dadurch gekennzeichnet,**
**dass** die Schaltvorrichtung (1, 19) Mittel zur Ermittlung und zum Vergleich auf den zeitlichen Verlauf bezogener Soll- und Istwerte für die Steuerspannung der Zündspule (3, 21) in der Endstufe unter Verwendung eines vom Steuergerät gelieferten Zündsignals sowie zur Regelung der Endstufe und damit eines Ein- und/oder Ausschaltsignals für die Zündspule (3, 21) derart, dass die Änderung der Steuerspannung im kontinuierlichen Zeitverlauf eine stetige Kurve mit endlicher Steigung beschreibt und somit die Flankensteilheit des Ein- und/oder Ausschaltsignals der Spule begrenzt wird, umfasst.

13. Schaltvorrichtung nach Anspruch 12,
**dadurch gekennzeichnet,**
**dass** die Mittel zum Vergleich der Soll- und Istwerte eine Vergleicherschaltung zur Bestimmung und Verarbeitung einer Regelabweichung umfassen.

14. Schaltvorrichtung nach Anspruch 13,
**dadurch gekennzeichnet,**
**dass** die Vergleicherschaltung einen Operationsverstärker (2) oder einen vergleichbaren Differenzverstärker umfasst.

15. Schaltvorrichtung nach einem der Ansprüche 12 bis 14,
**dadurch gekennzeichnet,**
**dass** die Schaltvorrichtung eine das Zündsignal des Steuergeräts als Eingabe erhaltende Eingangsschaltung mit einem Kondensator (5) sowie Mittel zur Bestimmung der Sollwerte über den Auf- und/oder Entladevorgang des Kondensators (5) umfasst.

16. Schaltvorrichtung nach einem der Ansprüche 12 oder 15,
**dadurch gekennzeichnet,**
**dass** die Mittel ein in einer Speichervorrichtung abgelegtes Programmmittel zum Soll-/Istwertvergleich umfassen.

17. Schaltvorrichtung nach einem der Ansprüche 12 bis 14 oder 16,
**dadurch gekennzeichnet,**
**dass** die Mittel ein in einer Speichervorrichtung abgelegtes Programmmittel zur Sollwertermittlung umfassen.

18. Schaltvorrichtung nach einer der Ansprüche 16 oder 17,
**dadurch gekennzeichnet,**
**dass** die Mittel zum definierten Setzen des Programmmittels über einen Resetport eines die Speichervorrichtung umfassenden Mikrocomputers in Abhängigkeit des Zündsignals des Steuergeräts ausgebildet sind.

19. Schaltvorrichtung nach einem der Ansprüche 12 bis 18,
**dadurch gekennzeichnet,**
**dass** die Mittel zur Regelung derart ausgebildet sind, dass die Steuerspannung im kontinuierlichen Zeitverlauf eine Rampe beschreibt.

20. Schaltvorrichtung nach Anspruch 19,
**dadurch gekennzeichnet,**
**dass** die Mittel zur Regelung derart ausgebildet sind,
**dass** die Spannungsrampe für einen möglichen Einschaltvorgang flacher verläuft als die Rampe für einen möglichen Ausschaltvorgang.

21. Schaltvorrichtung nach einem der Ansprüche 12 bis 20,
**dadurch gekennzeichnet,**
**dass** die Endstufe einen Leistungshalbleiter (4, 22), insbesondere einen bipolaren Transistor oder einen IGB-Transistor, zum Ansteuern der Zündspule umfasst.

22. Schaltvorrichtung nach Anspruch 21,
**dadurch gekennzeichnet,**
**dass** die Endstufe Mittel zur Ermittlung der Istwerte der Steuerspannung am Knotenpunkt zwischen Zündspule (3, 21) und Leistungshalbleiter (4, 22) umfasst.
